# EUROPEAN PATENT SPECIFICATION

(11) **EP 4 062 720 B1**
(45) Date of publication and mention of the grant of the patent: **09.07.2025**
(21) Application number: 20829703.6
(22) Date of filing: 10.11.2020
(51) Int. Cl.: H05K 5/02

(54) **HOUSING FOR A FILTER DEVICE WITH A CONNECTION BOX FOR CONNECTING TO AN ELECTRICAL GRID**
GEHÄUSE FÜR EINE FILTERVORRICHTUNG MIT EINEM ANSCHLUSSKASTEN ZUM VERBINDEN MIT EINEM ELEKTRISCHEN NETZ
BOÎTIER POUR UN DISPOSITIF DE FILTRATION DOTÉ D'UNE BOÎTE DE CONNEZION DESTINÉE À ÊTRE CONNECTÉE À UNE GRILLE ÉLECTRIQUE

(30) Priority: 18.11.2019 SI 201900230
(43) Date of publication of application: 28.09.2022
(73) Proprietor: BRS Raziskave in Sistemi D.o.o., 1260 Ljubljana - Polje (SI)
(72) Inventor: DIVJAK, Ivan, 1281 Kresnice (SI)
(74) Representative: Patentni Biro AF d.o.o.
(86) International application number: PCT/SI2020/050023
(87) International publication number: WO 2021/101454

(56) References cited:
- EP-A1- 1 852 941
- EP-A1- 3 648 256
- CN-U- 201 601 363
- GB-A- 1 308 053
- GB-A- 2 059 180
- JP-A- 2006 260 829
- JP-A- 2012 129 154
- US-B2- 9 246 256

## Description

### Field of the invention

The present invention belongs to the field of filtering electronic devices, more particularly to the field of construction of housings with terminal blocks for connecting into an electrical grid and similar devices.

### Background of the invention and the technical problem

Modern day electrical grids have to ensure distribution of electrical energy to users and also ensure communication between electrical devices via electrical grid (wires). Communication is often disturbed due to conductive interference caused by different electrical devices used at user location; therefore electrical grids have to incorporate filtering electronic devices for reducing disturbances in the frequency band used for communication.

Due to frequent use of modern measuring systems in the low-voltage electrical grids, where smart electricity meters communicate via the same electrical conductors as is used for distribution of electrical energy to users, the electrical grids require more and more filtering devices. Each filtering device has to be connected in the electrical grid in a way which requires a physical interruption of electrical energy, connection of conductors into the filtering device and out of it as well as re-connection of electrical energy. These are actions, which may be dangerous to the staff and/or can cause huge damage (in case of a fire, for example), different standards and rules define requirements for safe work, connection and operation of electrical devices in electrical grids.

Safety requirements for operation of electronic devices in low-voltage electrical grids in the EU are defined in the Directive 2014/35/EU, which has been used since 20.04.2016. In particular, the general and safety requirements for connecting filtering electronic devices into electrical grids are defined in standards EN 50065-4-1 and EN 50065-4-2, published on 01.02.2003. Standard EN 50065-4-1:2003 is for signals on low-voltage electrical installations in the frequency band 3kHz to 148,5kHz, while the part 4-1 is for low-voltage decoupling filters - general specification. Standard EN 50065-4-2:2003 is for signals on low-voltage electrical installations in the frequency band 3kHz to 148,5kHz and 1,6MHz to 30MHz, while the part 4-2 is for low voltage decoupling filters - safety requirements.

PLC filters are intended for reducing unwanted conductive disturbances in AMI-PLC systems under 150 kHz as well as up to 500 kHz for remote reading of smart electricity meters require a constructional solution of a housing with a terminal block for simple and reliable connection to the electrical grid.

The technical problem, which is solved by the present invention, is construction of the housing of a filtering electronic device to be connected in the electrical grid circuit, wherein the said housing will ensure easy and reliable electrical and mechanical connections between the electronic circuit and interrupted conductors of the electrical grid. The constructional design of the housing for safe installation and reliable connection of an electronic device, preferably PLC filter and similar devices should enable connection into one-phase or three-phase network, depending on the type of network into which the device will be connected. Input and output clips of devices have to enable electrical, mechanical and functional reliability in agreement with standards for such devices.

The geometry of the arrangement of connective clips and safety barriers in the terminal block has to enable suitable insulation and creepage distances as defined in the said standards, while at the same time the arrangement should ensure minimum dimensions of the housing and the terminal block for connection into conductors of one-phase or three-phase networks.

The housing construction has to enable good heat dissipation due to large circuit loads, but at the same time it has to ensure high electrical breakthrough strength at possible voltage surges in the electrical grids.

### State of the art

Different housings for electrical and electronic devices are known, but they differ from the present invention in their shape and their connection points. The closest known solution is the housing of the applicant, which has a slightly rounded outer shape and differently arranged connectors and intermediate barriers/walls.

The housing of one of the manufacturers of filtering devices is shaped so that the bottom part is a rectangular prism with a second smaller rectangular prism on it. At the side of the bottom prism openings for connective wires are provided, wherein the wires may be attached from above once the cover is opened. The shape of the housing and the connectors differs from the present invention.

Other manufacturers of similar filtering devices do not have similar solutions to the present invention, not in the market nor in patent databases.

Patent US9246256 relates to a terminal device, which includes a first cover portion to be positioned above the first screw terminals, wherein the first cover portion including the first operation openings which respectively expose screws of the first screw terminals, a second cover portion to be positioned above the second screw terminals, the second cover portion including the second operation openings which respectively expose screws of the second screw terminals. And the terminal device further includes a connecting portion connecting the first cover portion with the second cover portion and including wire insertion holes through which electric wires connected to the first screw terminals respectively pass and wire insertion paths which communicate with the wire insertion holes and through which the electric wires respectively pass, each insertion path being provided on an upper surface of the second cover portion between two adjacent second operation openings

Patent application GB2059180 describes a terminal block insert that comprises a steel frame of rectangular cross-section, formed from sheet metal, and a strip of brass secured to the frame by interlocking tabs and notches. The frame has transverse threaded bores each for receiving a respective screw.

Patent application GB1308053 discloses an adapter for connecting the ends of conductors to a terminal, e.g., a terminal of a socket outlet, batten lamp holder or switch, and comprises a metal block having a through bore for receiving the conductor ends with two independent spaced means for securing them therein, and a spigot for making a connection with a bore in the terminal. The rectangular brass block has two pinch screws each of which secures the ends of two aluminium conductors within the throughbore and the spigot extends parallel to and coplanar with the screws. The embodiment shown has a second throughbore with pinch screws for receiving a spur conductor. The spigot may be integral with the block or screw-threadedly attached thereto.

Patent application EP1852941 discloses a connector for a terminal block for adjoining a pair of wires for providing electrical conduction between the wires is disclosed. The connector has a cylindrical body having one screw hole near each end of the body and a wire end plate formed internally to and at substantially the longitudinal center of the body for limiting wire insertion. A conduction plate is inserted into the hollow space of the cylindrical body and has a length substantially the same as that of the cylindrical body along the longitudinal direction thereof. The conduction plate has a concaved surface conforming to the generally spherical cross section of the wires for partially enclosing the wires when inserted for adjoining. The concaved surface provides low electrical resistance between the adjoined wires when two screws mating with the screw holes are installed and each driven firmly onto the corresponding one of the adjoining wires thereby squeezing the wires firmly onto the conduction plate.

CN201601363 discloses a terminal block with a configuration which differs significantly from the present invention.

Patent application JP2006260829 discloses a lower-step terminal cover, provided with a pair of leg parts extending from each side in its movement direction, which is retained by the terminal board in free sliding movement by being inserted into a terminal insertion hole, and is free to move in the same plane with a terminal releasing face. As the lower-step terminal cover is moved, the terminal releasing face of the lower-step terminal board part is put out in a space between both leg parts to connect a connecting terminal with the counterpart terminal. Patent application JP2012129154 is an upgrade of the solution presented in document JP2006260829 and aims to provide a solution for a terminal block that prevents fire due to heat generation resulting from poor contacts. Upon connection of a plurality of input/output terminals for connecting a power source are installed with a terminal block, a heat reaction type foam material is installed opposite to the input/output terminals on a foam material installation section of a terminal attachment base. A poor contact is cancelled by expanding a volume of the foam material, when temperature reaches a predetermined temperature.

### Description of the solution of the technical problem

The essence of the housing with the terminal block according to the invention is that it comprises:
- a socket outlet box with at least two horizontal seats with partitions and a vertical dividing wall with openings at one end of the seats, the openings being adapted to receive connecting wires of the filter device or any other electronic device,
- at least two connection terminals which can be mounted in the horizontal seats of the socket outlet box, the connection terminals being provided with a longitudinal borehole and each with at least two rectangular threaded holes intended on one side of the connection terminal for attaching the wire to the filter device side with at least one screw and on the other side for fastening an electrical grid conductor with at least one screw,
- an upper part of the socket outlet box formed to cover the horizontal seats and the connection terminals, so that the screws for fixing the electrical grid conductors are accessible from the outside, and the openings for the electrical grid connection conductors are accessible from the outside,
- a cover for the upper part of the socket outlet box, which covers the screws for fixing the electrical grid conductors, and
- preferably also a tubular housing adapted to receive the filter device or any other electronic device, the tubular housing having an opening for mounting a socket outlet box on one side and an opening or a cover on the other.

The filter device or any other electronic device that needs to be connected to the electrical grid can be installed in the tubular housing. The terminal block comprises the socket outlet box, the upper portion of the socket outlet box with a cover, connection terminals and associated screws. The socket outlet box allows installation of connection terminals, which ensure fixing of the connecting wires of the filter device or any other electronic device with at least one screw on one side and the fixing of external electrical grid conductors with at least one, preferably two screws for better contact on the other side. Namely, the screws must securely fasten the connecting wires of the device and the electrical grid connecting wires (conductors), which is achieved by the prescribed screwing force or by doubling the screws, otherwise poor connections can occur, which can cause cracking, heating or even fire, since the common current of an individual customer-consumer or the entire flat, house or industrial facility flows through the metal connection terminals. Access to the screws is provided through the upper portion of the socket outlet box, and, to provide safety, the cover covers the screws in the threaded holes (to prevent contact and unscrewing of screws when voltage is applied) for attaching the connection cables to the electrical grid. The housing of the socket outlet box and the cover can be additionally equipped with an additional ring or a sealing screw for installing a seal, which prevents unauthorized opening of the cover on the socket outlet box.

The tubular housing with the filter or any other device arranged thereon and connected to the socket outlet box can be completely or partially sealed with a suitable material, preferably epoxy resin, which inseparably joins all said elements. Sealing with epoxy resin significantly improves the life span of the product, as it becomes a monolithic block, which cannot be penetrated by moisture and various particles that could impair the insulating properties. In addition, the elements sealed in the mass cannot move, therefore the degree of insulation is increased because the epoxy mass is a higher dielectric than air and the thermal conductivity is also improved, so the heat is dissipated faster through the mass outwards to the housing and the environment. This consequently means that the MTBF (mean time between failures) time is improved, i.e. the time elapsed between product failures or a measure of the reliability of a product or component. Similarly, before being installed in the tubular housing, the filter device can be surrounded by additional insulating plates in the form of a square, which can meet additional safety requirements for reinforced or double insulation of the device, which must be specifically marked on the device and properly checked in compliance with standards EN 50065-4-1 and EN 50065-4-2.

The metal connection terminal has any elongated shape, wherein the preferred shape is an elongated cuboid with square or rectangular side faces, wherein the said cuboid is provided with a round borehole along the horizontal axis. Perpendicularly to the longitudinal axis of the metal connection terminal at least one first threaded hole is provided on one side and at least one, preferably two second threaded holes, are provided on the other side. The metal connection terminals are separated from each other by partitions which are dimensioned in such a way as to increase the electrical breakdown strength and the creep distance between the metal connection terminals. The thicknesses of seats and partitions must meet the requirements for the material of the terminal block to achieve electrical breakdown strength, according to the safety category to be achieved with the device, and must also be properly checked in accordance with the recommendation of the Directive and standard EN 50065-4-1 and EN 50065- 4-2. The plastic materials used to make the components of the terminal block and the material used to seal the interior of the housing with the terminal block, which is usually an appropriate epoxy resin, must have good mechanical and electrical (insulating) properties, good heat dissipation and must also meet corresponding flammability standards in accordance with UL 94 or Glow Wire Flammability standards.

The material for manufacturing a terminal block is preferably a polycarbonate, to which about 10% of glass fibres have been added for reinforcement.

In case earthing of the metal housing is required for safety reasons or to prevent electromagnetic interference, this may be achieved by an additional connector on the terminal block or by a separate earthing conductor attached to the metal housing.

The housing according to the invention allows reliable connection of the electronic device to the electrical grid circuit, where the currents exceed 10 A, or even exceed 100 A, so it is desirable that the current flows from the device to the connecting cables and back with smallest possible resistance. Therefore, the metal connection terminals proposed in the invention are square or rectangular in cross-section with a longitudinal bore having a diameter exceeding the diameters of the connection conductors, dimensioned for an individual current load determined by a fuse or protective element in the electrical grid. The metal connection terminals are made of well-conducting materials, such as copper or brass. To increase corrosion resistance due to the climatic influences of the environment, the connection terminals are preferably nickel-plated or tinned.

The housing according to the invention is also suitable for measuring, coupling, blocking, transceiving, protective and other devices. If the devices are intended for single-phase or multi-phase electrical grids, the terminal block is narrower or wider, so it is adaptable to the required number of connectors, in general for each phase 2 connectors for input and output of a phase conductor and additionally 1 connector for the neutral conductor. This means 3 connectors for a single-phase device and 7 connectors for a three-phase device. For some types of devices, it is also necessary to split the neutral conductor to the inlet and outlet of the neutral conductor, which means 4 connectors for a single-phase device and 8 connectors for a three-phase device. Some types of electronic devices (measuring, blocking) would only require two connectors, for a single-phase connection of a phase and neutral conductor and four connectors for three-phase conductors and a neutral conductor.

The present solution allows connection of devices to the electrical grid downstream of electricity meters with existing protective elements (fuses), which ensures safe operation by observing the prescribed dimensions of conductor diameters, mutual distances, partition wall thickness for allowable current loads and rated currents of individual filter devices. Protective elements such as fuses, arresters and the like can also be arranged in the housing of a filter device with a terminal block or other electronic device.

Standards EN 50065-4-1: 2003 and EN 50065-4-2: 2003 for filter and other electronic devices have been taken into account during design of the housing for the filter device with the terminal block for direct connection to the electrical grid, while for all materials used, the applicable restrictions for marketing or use of certain hazardous substances and preparations or RoHS regulations have also been taken into account. This is also included in manuals with tables for dimensioning conductors, permissible current loads for copper conductors with PVC insulation, rated currents of fuses, correlation factors and conditions for dimensioning rated current and other parameters.

The invention allows connection of a filter device or any other device to the electrical grid without or with a fuse. The housing according to the invention enables reliable electrical and mechanical connections between the electronic circuit and interrupted electrical grid conductors.

The housing for a filtering device with the terminal block for connecting into an electrical grid according to the invention will be described in further detail based on exemplary embodiments and figures, which show:
- Figure 1: The housing assembly with the terminal block for a single-phase device
- Figure 2: ground plan of the housing for a single-phase device without the cap
- Figure 3: section B-B shown in Figure 2
- Figure 4: the housing with the terminal block for a single-phase device with the cap
- Figure 5: The housing with the terminal block for a three-phase device without the cap

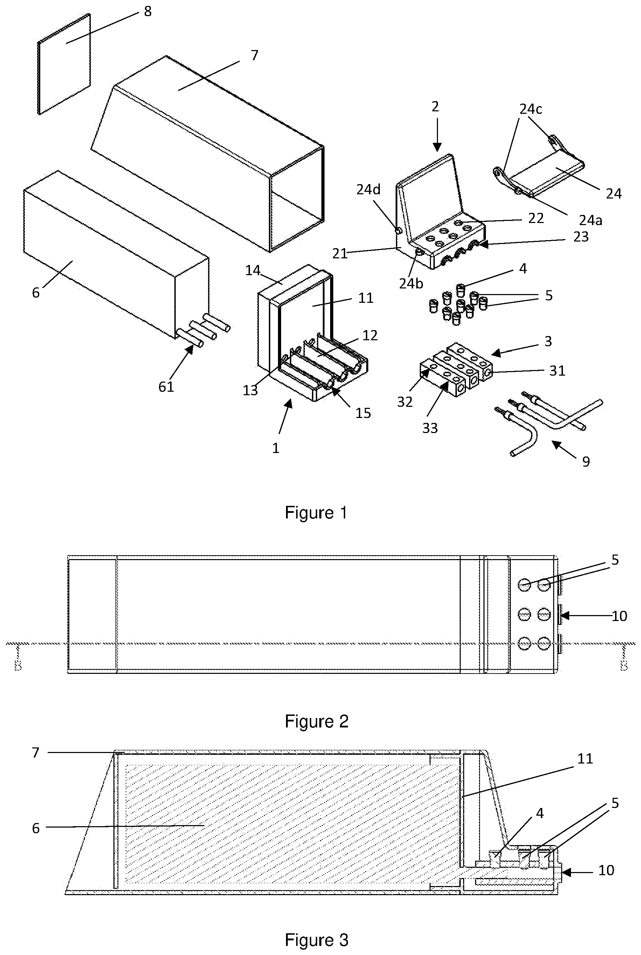

A possible embodiment of the housing with the terminal block for connecting a filter device to the electrical grid as shown in Figure 1 is based on the construction of a socket outlet box 1 that separates the filter device 6 with a vertical dividing wall 11, wherein the filter device has to be connected without an additional fuse to the electrical grid, and the terminal block, with which the filter device 6 can be connected to the electrical grid. The terminal block consists of the socket outlet box 1, an upper portion 2 of the socket outlet box 1 with a cover 24, a metal connection terminal 3 and the associated screws 4 and 5. The cover 24 is pivotally attached to the upper portion 2 via two levers 24c, which are fastened to the upper portion 2 with an axle 24d.

As shown in Figure 1, the housing according to the embodiment includes the socket outlet box 1, openings 13 in the vertical dividing wall 11 and horizontal seats with partitions 12, which allow arrangement of any metal connection terminals 3. The metal connection terminal 3 has any elongated shape, preferably an elongated cuboid with side faces of square or rectangular shape having a round hole 31 provided along the horizontal axis. One first threaded hole 32 and two second threaded holes 33 are provided perpendicularly to the longitudinal axis of the metal connection terminal 3. When connectors 61 of the filter device 6 are pushed through the openings 13 of the dividing wall 11 into a pipe 31 of the metal connection terminal 3 from the dividing wall 11 side, the connecting wires 61 are fastened to the metal connection terminals 3 by means of screws 4 through the threaded opening 32 (see Fig. 1). Instead of screws 4, the connecting wires 61 can be fastened to the metal connection terminal 3 by welding, where the principle of fusion welding with electricity can be applied.

The upper portion 2 of the socket outlet box 1 is shaped so that it is attached to the socket outlet box 1 with an edge 21, wherein the screws 5 screwed into the threaded holes 33 on the connection terminals 3 engage the openings 22 on the upper portion 2 of the socket outlet box 1, the screws 5 being screwed through said holes into the threaded openings 33 on the metal connection terminals 3 that allow the attachment of external connection conductors 9 into openings 10 on the front side of the terminal block so as to ensure the connection of the filter device 6 to the electrical grid. Also, semi-circular protrusions 15 of the socket outlet box 1 match semi-circular protrusions 23 of the upper portion 2 of the socket outlet box 1 so that together they form the openings 10, the diameter of which exactly fits the diameters of the openings of the round tubes 31 in the metal connection terminals 3. A cover 24 is arranged on the upper portion 2, which covers the openings 22 and covers the screws for attaching the connecting conductors to the electrical grid, in order to prevent contact and unscrewing of the screws when voltage is applied. The upper portion 2 of the socket outlet box 1 and the cover 24 can be equipped with an additional ring 24a or a sealing screw for installing a seal, which prevents unauthorized opening of the cover on the socket outlet box 1a.

The procedure for connecting a filter device to an electrical grid with the housing with the terminal block includes the following. The connecting wires 61 of the filter device 6 are attached to the metal connection terminals 3 by being pushed through the designated openings 13 in the dividing wall 11 of the socket outlet box 1 and tightened with screws 4. A tubular housing 7 is pulled over the filter device 6 and attached to a frame 14 of the socket outlet box 1, from the other side, it can be sealed with an appropriate epoxy resin or closed with a cover 8. The epoxy resin can be poured only partially in order to cover the connecting wires 61 and connect the tubular housing 7 with the socket outlet box 1. In this case, the filter device remains unsealed and the tubular housing 7 must be closed with the cover 8. In case the epoxy resin is poured to the top of the tubular housing 7, the filter device is completely sealed and the cover 8 is not needed. After attaching all the connecting wires 61 of the filter device 6 to the metal connection terminals 3 with screws 4, the upper portion 2 of the socket outlet box 1 is mounted onto the socket outlet box 1. The upper part 2 of the socket outlet box 1 with the first ring 24a is provided with a cover 24 with a second ring 24b. A security seal tape is arranged through the first and second rings. Thus, the filter device 6 in the housing 7 with the connection socket is ready for being connected to the electrical grid, since the upper portion 2 allows the connection of the housing with the filter device and the terminal block to the electrical grid with at least one screw 5 per connection cable, preferably with two, which allows easy and reliable fastening of external connection conductors 9 of the electrical grid. The upper portion 2 must be mounted onto the socket outlet box 1 before the electrical grid connection cables are connected to the terminal block.

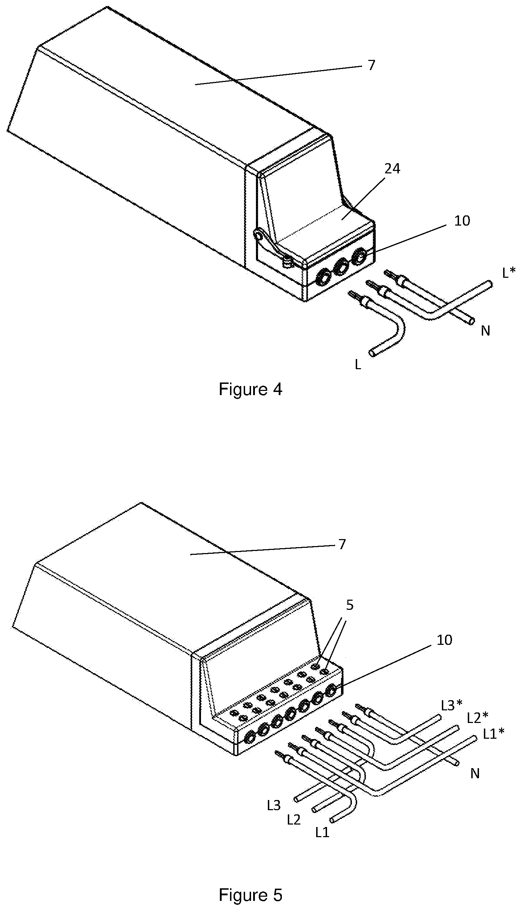

The connection to the electrical grid is achieved so that the first connecting wire 61 is inserted into a first channel 31 of the first connection terminal 3 and fastened with the first screw 4 through the first threaded opening 32. On the other side of the first connection terminal 3, an input connection cable L of the electrical grid is inserted into the first channel 31 through the first opening 10 of the terminal block and fastened with the first screw 5 (see Figure 4). The second connecting wire 61 is inserted into a second channel 31 of the second connection terminal 3 and fastened with a second screw 4 through the second threaded opening 32. On the other side of the second connection terminal 3, an input connection cable L* of the electrical grid is inserted into the second channel 31 through the second opening 10 of the terminal block and fastened with the second screw 5. The third connecting wire 61 is inserted into a third channel 31 of the third connection terminal 3 and fastened with a third screw 4 through the third threaded opening 32. On the other side of the third connection terminal 3, a neutral connection cable N of the electrical grid is inserted into the third channel 31 through the second opening 10 of the terminal block and fastened with the third screw 5. The conductors L, L* and N of the single-phase electrical grid are inserted into the terminal blocks and fastened with a screw 5, which are accessible for fastening (screwing) from the outside of the housing with the terminal block.

The connection of the device 6 with the connecting wires 61 with screws 4 or of the connecting wires 9 to the electrical grid with screws 5 can be done with one screw per single metal connection terminal or with two screws to increase the reliability of the joints. The screws 4 and 5 used can have different notches (straight, cross, hex, etc.) to increase the screwing force or to prevent unauthorized access to the connections of the device and electrical grid power lines, as screws with special notches require specially adapted screwdrivers. In the embodiment for a single-phase network shown in Figure 4, the connection conductors 9 are marked as L, L* and N.

As shown in Figure 5, the housing with the terminal block for a three-phase device according to the invention includes the tubular housing and the socket outlet box with openings in the vertical dividing wall and horizontal seats with partitions, which allow the arrangement of metal connection terminals as in the housing for a single-phase device. Through the openings, the input connection cables L1, L1 and L3 of the three-phase electrical grid are inserted into the first three tubes of the metal connection terminals, the output connection cables L1*, L1* and L3* of the three-phase electrical grid are inserted into the other three tubes of the metal connection terminals, and the neutral conductor N is inserted into the seventh tube of the metal connection terminals. The housing for a three-phase device includes identically shaped connection terminals mounted in seats with partitions in the socket outlet box, the number of these seats and terminals being adapted to the three-phase electrical device. In the second embodiment (Figure 5), the connection conductors 9 from the first embodiment for the single-phase electrical grid (Figure 4) are marked as L1, L2, L3, L1*, L2*, L3* and N for the three-phase electrical grid.

## Claims

1. A housing for a filtering device (6) with a terminal block for connecting into an electrical grid, wherein the said terminal block comprises:
- a socket outlet box (1) with at least two horizontal seats (12) with partitions and a vertical dividing wall (11) with openings (13) at one end of the seats (12), the openings (13) being adapted to receive connecting wires (61) of a filtering device (6) or any other electronic device,
- at least two connection terminals (3), which are mounted in the horizontal seats (12) of the socket outlet box (1), each of the connection terminals (3) being provided with a longitudinal borehole (31) and with at least two perpendicular threaded holes (32, 33), one each end of each connection terminal (3), the threaded hole (32) on the filtering device (6) end is provided with a screw (4) for fastening a connecting wire (61) from the filtering device (6), while the threaded hole (33) on the other end of the connection terminal (3) is provided with a screw (5) for fastening an electrical grid conductor (9),
- an upper portion (2) of the terminal block is attached to the socket outlet box (1) and formed so as to cover the horizontal seats (12) and the connection terminals (3), so that the screws (5) for fixing the electrical grid conductors (9) are accessible from the outside of the terminal block via openings (22) and the upper portion (2) is shaped such that together with the socket outlet box (1) it forms openings (10) for the electrical grid conductors (9) to be inserted, wherein the openings (10) are accessible from the outside of the terminal block,
**characterized in that** a cover (24) is provided on the upper part (2) of the terminal block through which the screws (5) of the connection terminals (3) are accessible via openings (22),
wherein said cover (24) is configured to cover the openings (22) and the screws (5) in the threaded holes (33) in order to prevent contact and unscrewing of the screws (5) when voltage is applied.

2. The housing for a filtering device (6) with the terminal block for connecting into an electrical grid according to claim 1, **characterized in that** a tubular housing (7) is arranged to receive a filter (6) or any other electronic device, wherein the tubular housing (7) has on one side an opening for installation of the socket outlet box (1) and on the other side an opening and a cover (8).

3. The housing for a filtering device (6) with the terminal block for connecting into an electrical grid according to claim 2, **characterized in that** the housing (7) with the installed filter (6) or any other electronic device connected to the terminal block is entirely or partially filled with a suitable material, preferably with epoxy resin, which inseparably merges all said elements.

4. The housing for a filtering device (6) with the terminal block for connecting into an electrical grid according to any of the preceding claims, **characterized in that** the connection terminals (3) are metallic and have any elongated shape, preferably an elongated cuboid with square or rectangular sides; the connection terminals (3) having preferably two second threaded holes (33).

5. The housing for a filtering device (6) with the terminal block for connecting into an electrical grid according to any of the preceding claims, **characterized in that** the partitions are dimensioned in agreement with standards EN 50065-4-1:2003 and EN 50065-4-2:2003 so that they increase electrical breakthrough strength and creepage distance between connection terminals (3).

6. The housing for a filtering device (6) with the terminal block for connecting into an electrical grid according to any of the preceding claims, **characterized in that** the connection terminals (3) are made of copper, brass or any other well-conducting material; and that the connecting terminals (3) are nickel-platted or tinned.

7. The housing for a filtering device (6) with the terminal block for connecting into an electrical grid according to any of the preceding claims, **characterized in that** the upper part (2) of the terminal block is shaped so that it engages with the socket outlet box (1) with its edge (21) wherein the screws (5), screwed into threaded holes (33) on connection terminals (3) engage with openings (22) on the upper part (2) of the terminal block, through which screws (5) are screwed into threaded holes (33) on connection terminals (3), which enable attachment of electrical grid conductors (9) into openings (10) on the front side of the terminal block, so that connection of the device (6) into electrical grid is enabled; semi-circular protrusions (15) of the socket outlet box (1) engage with semi-circular protrusions (23) of the upper part (2) of the terminal block so that they together form the openings (10) having a diameter which exactly corresponds to the diameter of the holes of the through-holes (31) in the connection terminals (3).

8. The housing for a filtering device (6) with the terminal block for connecting into an electrical grid according to any of the preceding claims, **characterized in that** the housing is made of a material with good mechanical and electrical (insulation) characteristics and ensuring good heat dissipation, wherein the preferred choice for the terminal block is polycarbonate with added approximately 10% of glass fibers for reinforcement.

9. The housing for a filtering device (6) with the terminal block for connecting into an electrical grid according to any of the preceding claims, **characterized in that** the upper portion (2) and the cover (24) are equipped with an additional ring (24a, 24b) or a sealing screw for placing a seal that prevents unauthorized opening of the cover (24) on the terminal block.

10. The housing for a filtering device (6) with the terminal block for connecting into an electrical grid according to any of the preceding claims, **characterized in that** the terminal block is adapted with regards to the connection of the device (6) into a one-phase or multi-phase electrical grid, generally two connection terminals (3) for each phase for an inlet and outlet and additionally one connection terminal (3) for a neutral conductor, which means three connection terminals (3) for one-phase or seven connection terminals (3) for a three-phase device (6), respectively, wherein optionally the neutral conductor can be divided into an inlet and outlet, which means four connection terminals (3) for one-phase device (6) or eight connection terminals (3) for a three-phase device (6), are required, respectively.

11. A procedure for connecting a filtering device (6) into an electrical grid with the housing with the terminal block according to any of the preceding claims, wherein the procedure comprises the following steps:
- the connecting wires (61) of the filter device (6) are installed through the openings (13) in the partition wall (11) of the socket outlet box (1) and into the connection terminals (3);
- the filter device (6) is installed in the tubular housing (7), which is installed on the partition wall (11) of the socket outlet box (1);
- into the tubular housing (7) epoxy resin is poured, so that the filter device (6) and the terminal block are connected into an inseparable entity;
- on the socket outlet box (1) the upper part (2) of the terminal block is mounted, said upper part (2) covering the connection terminals (3) together with the screws (4);
- into the connection terminals (3) electrical grid conductors (9) are installed with at least one, preferably two screws (5), through openings (22) on the upper part (2) of the terminal block.

12. Use of the housing according to any of the claims 1-10 for connecting a filtering device (6) into a circuit of one-phase or multi-phase grid.

13. An electronic device with the housing according to any claim from 1 to 10, wherein the electronic device is a filtering, measuring, connecting, blocking, transceiving or a protecting device.

## Patentansprüche

1. Gehäuse für eine Filtervorrichtung (6) mit einem Anschlusskasten zum Verbinden mit einem elektrischen Netz, wobei der Anschlusskasten Folgendesumfasst:
- eine Steckdosenbox (1) mit mindestens zwei horizontalen Aufnahmen (12) mit Unterteilungen und einer vertikalen Trennwand (11) mit Öffnungen (13) an einem Ende der Aufnahmen (12), wobei die Öffnungen (13) zur Aufnahme von Anschlussdrähten (61) einer Filtervorrichtung (6) oder einer anderen elektronischen Vorrichtung geeignet sind,
- mindestens zwei Anschlussklemmen (3), die in den horizontalen Aufnahmen (12) der Steckdosenbox (1) montiert sind, wobei jede der Anschlussklemmen (3) mit einer Längsbohrung (31) und mindestens zwei senkrechten Gewindelöchern (32, 33) versehen ist, eines an jedem Ende jeder Anschlussklemme (3), wobei das Gewindeloch (32) am Ende der Filtervorrichtung (6) mit einer Schraube (4) zum Befestigen eines Anschlussdrahtes (61) von der Filtervorrichtung (6) versehen ist, während das Gewindeloch (33) am anderen Ende der Anschlussklemme (3) mit einer Schraube (5) zum Befestigen eines elektrischen Netzleiters (9) versehen ist,
- ein oberer Teil (2) des Klemmenblocks an der Steckdosenbox (1) befestigt ist und so ausgebildet ist, um die horizontalen Aufnahmen (12) und die Anschlussklemmen (3) abzudecken, sodass die Schrauben (5) zum Befestigen der elektrischen Netzleiter (9) von der Außenseite des Klemmenblocks über Öffnungen (22) zugänglich sind, und der obere Teil (2) so geformt ist, dass zusammen mit der Steckdosenbox (1) Öffnungen zum Einführen der elektrischen Netzleiter (9) vorhanden sind, wobei die Öffnungen (10) von der Außenseite des Klemmenblocks zugänglich sind,
**dadurch gekennzeichnet, dass** am oberen Teil (2) des Klemmenblocks eine Abdeckung (24) vorgesehen ist, durch die die Schrauben (5) der Anschlussklemme (3) über Öffnungen (22) zugänglich sind, wobei die Abdeckung (24) konfiguriert ist, um die Öffnungen (22) und die Schrauben (5) in den Gewindelöchern (33) abzudecken, um ein Berühren und Herausdrehen der Schrauben (5) bei angelegter Spannung zu verhindern.

2. Gehäuse für eine Filtervorrichtung (6) mit einem Anschlusskasten zum Verbinden mit einem elektrischen Netz nach Anspruch 1, **dadurch gekennzeichnet, dass** ein röhrenförmiges Gehäuse (7) zur Aufnahme eines Filters (6) oder einer anderen elektronischen Vorrichtung vorgesehen ist, wobei das röhrenförmige Gehäuse (7) auf der einen Seite eine Öffnung zur Installation der Steckdosenbox (1) und auf der anderen Seite eine Öffnung und eine Abdeckung (8) aufweist.

3. Gehäuse für eine Filtervorrichtung (6) mit einem Anschlusskasten zum Verbinden mit einem elektrischen Netz nach Anspruch 2, **dadurch gekennzeichnet, dass** das Gehäuse (7) mit dem eingebauten Filter (6) oder einer anderen mit dem Anschlusskasten verbunden elektronischen Vorrichtung ganz oder teilweise mit einem geeigneten Material, vorzugsweise mit Epoxidharz, gefüllt ist, das alle genannten Elemente untrennbar miteinander verbindet.

4. Gehäuse für eine Filtervorrichtung (6) mit einem Anschlusskasten zum Verbinden mit einem elektrischen Netz nach einem der vorstehenden Ansprüche, **dadurch gekennzeichnet, dass** die Anschlussklemmen (3) metallisch sind und eine beliebige längliche Form aufweisen, vorzugsweise einen länglichen Quader mit quadratischen oder rechteckigen Seiten; wobei die Anschlussklemmen (3) vorzugsweise zwei zweite Gewindelöcher (33) aufweisen.

5. Gehäuse für eine Filtervorrichtung (6) mit einem Anschlusskasten zum Verbinden mit einem elektrischen Netz nach einem der vorstehenden Ansprüche, **dadurch gekennzeichnet, dass** die Trennwände gemäß den Normen EN 50065-4-1:2003 und EN 50065-4-2:2003 so dimensioniert sind, dass sie die elektrische Durchbruchfestigkeit und die Kriechstrecke zwischen den Anschlussklemmen (3) erhöhen.

6. Gehäuse für eine Filtervorrichtung (6) mit einem Anschlusskasten zum Verbinden mit einem elektrischen Netz nach einem der vorstehenden Ansprüche, **dadurch gekennzeichnet, dass** die Anschlussklemmen (3) aus Kupfer, Messing oder einem anderen gut leitenden Material bestehen und dass die Anschlussklemmen (3) vernickelt oder verzinnt sind.

7. Gehäuse für eine Filtervorrichtung (6) mit einem Anschlusskasten zum Verbinden mit einem elektrischen Netz nach einem der vorstehenden Ansprüche, **dadurch gekennzeichnet, dass** der obere Teil (2) des Anschlusskastens so geformt ist, um mit seiner Kante (21) in das Gehäuse der Steckdosenbox (1) einzugreifen, wobei die in Gewindelöcher (33) an den Anschlussklemmen (3) eingeschraubten Schrauben (5) in Öffnungen (22) am oberen Teil (2) des Anschlusskastens eingreifen, durch die Schrauben (5) in Gewindelöcher (33) an den Anschlussklemmen (3) eingeschraubt werden, welche die Befestigung von elektrischen Netzleitern (9) in Öffnungen (10) an der Vorderseite des Anschlusskastens ermöglichen, sodass die Verbindung der Vorrichtung (6) mit dem elektrischen Netz ermöglicht wird; halbrunde Vorsprünge (15) der Steckdosenbox (1) in halbrunde Vorsprünge (23) des oberen Teils (2) des Klemmenblocks so eingreifen, dass sie zusammen Öffnungen (10) bilden, deren Durchmesser genau dem Lochdurchmesser der Durchgangslöcher (31) in den Anschlussklemmen (3) entspricht.

8. Gehäuse für eine Filtervorrichtung (6) mit einem Anschlusskasten zum Verbinden mit einem elektrischen Netz nach einem der vorstehenden Ansprüche, **dadurch gekennzeichnet, dass** das Gehäuse aus einem Material mit guten mechanischen und elektrischen (Isolier-)Eigenschaften besteht, das eine gute Wärmeableitung gewährleistet, wobei die bevorzugte Auswahl für den Anschlusskasten Polycarbonat mit ungefähr 10 % zusätzlichen Glasfasern zur Verstärkung ist.

9. Gehäuse für eine Filtervorrichtung (6) mit einem Anschlusskasten zum Verbinden mit einem elektrischen Netz nach einem der vorstehenden Ansprüche, **dadurch gekennzeichnet, dass** der obere Teil (2) und die Abdeckung (24) mit einem zusätzlichen Ring (24a, 24b) oder einer Plombierschraube zum Anbringen einer Plombe ausgestattet sind, die ein unbefugtes Öffnen der Abdeckung (24) am Anschlusskasten verhindert.

10. Gehäuse für eine Filtervorrichtung (6) mit einem Anschlusskasten zum Verbinden mit einem elektrischen Netz nach einem der vorstehenden Ansprüche, **dadurch gekennzeichnet, dass** der Anschlusskasten im Hinblick auf die Verbindung mit der Vorrichtung (6) an ein einphasiges oder mehrphasiges elektrisches Netz angepasst ist, im Allgemeinen zwei Anschlussklemmen (3) für jede Phase für Zu- und Abgang und zusätzlich eine Anschlussklemme (3) für einen Neutralleiter, d. h. drei Anschlussklemmen (3) für eine einphasige bzw. sieben Anschlussklemmen (3) für eine dreiphasige Vorrichtung (6), wobei optional der Neutralleiter in Zu- und Abgang aufgeteilt werden kann, d.h. vier Anschlussklemmen (3) für eine einphasige Vorrichtung (6) bzw. acht Anschlussklemmen (3) für eine dreiphasige Vorrichtung (6) erforderlich sind.

11. Verfahren zum Verbinden einer Filtervorrichtung (6) mit einem elektrischen Netz mit dem Gehäuse mit dem Anschlusskasten nach einem der vorstehenden Ansprüche, wobei das Verfahren die folgenden Schritte umfasst:
- die Anschlussdrähte (61) der Filtervorrichtung (6) werden durch die Öffnungen (13) in der Trennwand (11) der Steckdosenbox (1) in die Anschlussklemmen (3) eingeführt;
- die Filtervorrichtung (6) ist in dem röhrenförmigen Gehäuse (7) eingebaut, das an der Trennwand (11) der Steckdosenbox (1) montiert ist;
- in das röhrenförmige Gehäuse (7) wird Epoxidharz eingegossen, sodass die Filtervorrichtung (6) und der Anschlusskasten zu einer untrennbaren Einheit verbunden werden;
- auf der Steckdosenbox (1) wird der obere Teil (2) des Klemmenblocks montiert, wobei der obere Teil (2) die Anschlussklemmen (3) zusammen mit den Schrauben (4) abdeckt;
- in die Anschlussklemmen (3) werden elektrische Netzleiter (9) mit mindestens einer, vorzugsweise zwei Schrauben (5) durch Öffnungen (22) am oberen Teil des Klemmenblocks (2) eingeführt.

12. Verwendung des Gehäuses nach einem der Ansprüche 1 bis 10 zum Verbinden einer Filtervorrichtung (6) mit einem Stromkreis eines einphasigen oder mehrphasigen Netzes.

13. Elektronische Vorrichtung mit dem Gehäuse nach einem der Ansprüche 1 bis 10, wobei die elektronische Vorrichtung eine Filter-, Mess-, Verbindungs-, Sperr-, Sende-/Empfangs- oder Schutzvorrichtung ist.

## Revendications

1. Boîtier pour un dispositif de filtration (6) doté d'une boîte de connexion destinée à être connectée à une grille électrique, ladite boîte de connexion comprenant :
- une boîte de dérivation (1) dotée d'au moins deux logements horizontaux (12) avec des partitions et une paroi de séparation verticale (11) dotée d'ouvertures (13) à une extrémité des logements (12), les ouvertures (13) étant conçues pour recevoir les fils de raccordement (61) d'un dispositif de filtration (6) ou tout autre appareil électronique,
- au moins deux bornes de connexion (3), qui sont montés sur les logements horizontaux (12) de la boîte de dérivation (1), chacun des bornes de connexion (3) étant pourvu d'un trou percé longitudinal (31) et d'au moins deux trous filetés perpendiculaires (32, 33), un à chaque extrémité de chaque borne de connexion (3) ; le trou fileté (32) à l'extrémité du dispositif de filtration (6) est pourvu d'une vis (4) pour la fixation d'un fil de raccordement (61) provenant du dispositif de filtration (6), tandis que le trou fileté (33) à l'autre extrémité de la borne de connexion (3) est pourvu d'une vis (5) pour la fixation d'un fil provenant de la grille électrique (9),
- une portion supérieure (2) de la boîte de connexion est fixée à la boîte de dérivation (1) et a une forme conçue pour recouvrir les logements horizontaux (12) et les bornes de connexion (3), de façon à ce que les vis (5) de fixation des fils de la grille électrique (9) soient accessibles depuis l'extérieur de la boîte de connexion via les ouvertures (22), et la portion supérieure (2) a une forme conçue pour que conjointement avec les ouvertures de la boîte de dérivation (1), les fils provenant de la grille électrique (9) puissent être insérés, les ouvertures (10) étant accessibles depuis l'extérieur de la boîte de connexion,
**caractérisée par le fait qu'**un couvercle (24) est présent sur la partie supérieure (2) de la boîte de connexion à travers lequel les vis (5) de la borne de connexion (3) sont accessibles via les ouvertures (22), ledit couvercle (24) étant conçu pour recouvrir les ouvertures (22) et les vis (5) dans les trous filetés (33) afin de prévenir tout contact et le desserrage des vis (5) quand la tension est appliquée.

2. Boîtier pour un dispositif de filtration (6) doté d'une boîte de connexion destinée à être connectée à une grille électrique selon la revendication 1, **caractérisé par le fait qu'**un logement tubulaire (7) est conçu pour recevoir un filtre (6) ou tout autre dispositif électronique, le logement tubulaire (7) ayant sur un côté une ouverture pour l'installation de la boîte de dérivation (1) et sur l'autre côté une ouverture et un couvercle (8).

3. Boîtier pour un dispositif de filtration (6) doté d'une boîte de connexion destinée à être connectée à une grille électrique selon la revendication 2, **caractérisé par le fait que** le boîtier (7) avec filtre installé (6), ou tout autre appareil électronique raccordé à la boîte de connexion, est entièrement ou partiellement rempli d'un matériau approprié, de préférence de la résine époxy, qui unit la totalité desdits éléments de façon inséparable.

4. Boîtier pour un dispositif de filtration (6) doté d'une boîte de connexion destinée à être connectée à une grille électrique selon l'une quelconque des revendications précédentes, **caractérisé par le fait que** les bornes de connexion (3) sont métalliques et ont une forme allongée, de préférence une forme cuboïde allongée avec des côtés carrés ou rectangulaires ; les bornes de connexion (3) ayant de préférence deux trous filetés (33).

5. Boîtier pour un dispositif de filtration (6) doté d'une boîte de connexion destinée à être connectée à une grille électrique selon l'une quelconque des revendications précédentes, **caractérisé par le fait que** les partitions sont dimensionnées conformément aux normes EN 50065-4-1:2003 et EN 50065-4-2:2003, de façon à augmenter la rigidité diélectrique et la ligne de fuite entre les bornes de connexion (3).

6. Boîtier pour un dispositif de filtration (6) doté d'une boîte de connexion destinée à être connectée à une grille électrique selon l'une quelconque des revendications précédentes, **caractérisé par le fait que** les bornes de connexion (3) sont constituées de cuivre, de laiton ou de tout autre matériau conducteur performant ; et **par le fait que** les bornes de connexion (3) sont nickelés ou étamés.

7. Boîtier pour un dispositif de filtration (6) doté d'une boîte de connexion destinée à être connectée à une grille électrique selon l'une quelconque des revendications précédentes, **caractérisé par le fait que** la partie supérieure (2) de la boîte de connexion a une forme qui fait qu'elle s'enclenche dans la boîte de dérivation (1) par le côté (21), où les vis (5), vissées dans les trous filetés (33) sur les bornes de connexion (3), s'enclenchent dans les ouvertures (22) sur la partie supérieure (2) de la boîte de connexion, à travers laquelle les vis (5) sont vissées dans les trous filetés (33) sur les bornes de connexion (3), ce qui permet la fixation des fils provenant de la grille électrique (9) dans les ouvertures (10) sur la face avant de la boîte de connexion, pour que le raccordement du dispositif (6) à la grille électrique soit possible ; des protubérances semi-circulaires (15) sur la boîte de dérivation (1) s'enclenche dans les protubérances semi-circulaires (23) de la partie supérieure (2) de la boîte de connexion, de façon à former conjointement les ouvertures (10) ayant un diamètre qui correspond exactement au diamètre des ouvertures des trous de passage (31) sur les bornes de connexion (3).

8. Boîtier pour un dispositif de filtration (6) doté d'une boîte de connexion destinée à être connectée à une grille électrique selon l'une quelconque des revendications précédentes, **caractérisé par le fait que** le boîtier est composé d'un matériau ayant de bonnes caractéristiques mécaniques et électriques (isolation), tandis que le choix privilégié pour la boîte de connexion est le polycarbonate additionné d'environ 10 % de fibres de verre à des fins de renforcement.

9. Boîtier pour un dispositif de filtration (6) doté d'une boîte de connexion destinée à être connectée à une grille électrique selon l'une quelconque des revendications précédentes, **caractérisé par le fait que** la portion supérieure (2) et le couvercle (24) sont munis d'une bague supplémentaire (24a, 24b) ou d'une vis de scellement qui empêche l'ouverture non autorisée du couvercle (24) de la boîte de connexion.

10. Boîtier pour un dispositif de filtration (6) doté d'une boîte de connexion destinée à être connectée à une grille électrique selon l'une quelconque des revendications précédentes, **caractérisé par le fait que** la boîte de connexion est compatible pour ce qui est du raccordement du dispositif (6) à la grille monophasée ou à phases multiples, en général deux bornes de connexion (3) pour chaque phase pour l'arrivée et la sortie et en supplément une borne de connexion (3) pour le fil neutre, ce qui signifie trois bornes de connexion (3) pour le monophasé ou sept bornes de connexion (3) pour un dispositif en triphasé (6), respectivement, où facultativement le fil neutre peut être divisé en une arrivée et une sortie, ce qui signifie que quatre bornes de connexion (3) pour un dispositif monophasé (6) ou huit bornes de connexion (3) pour un dispositif triphasé (6) sont nécessaires, respectivement.

11. Un procédé pour raccorder un dispositif de filtration (6) à une grille électrique par le biais d'un boîtier équipé d'une boîte de connexion selon l'une quelconque des revendications précédentes, le procédé comprenant les étapes suivantes :
- les fils de raccordement (61) du dispositif de filtration (6) sont installés à travers les ouvertures (13) de la paroi de partition (11) de la boîte de dérivation (1) et sur les bornes de connexion (3) ;
- le dispositif de filtration (6) est installé dans le logement tubulaire (7) qui est luimême installé sur la paroi de partition (11) de la boîte de dérivation (1) ;
- de la résine époxy est versée dans le logement tubulaire (7), de façon à ce le dispositif de filtration (6) et la boîte de connexion soient connectés en un tout inséparable ;
- la partie supérieure (2) de la boîte de connexion est montée sur la boîte de dérivation (1), ladite partie supérieure (2) couvrant les bornes de connexion (3) ainsi que les vis (4) ;
- sur les bornes de connexion (3), des fils provenant de la grille électriques (9) sont installés avec au moins une, de préférence deux vis (5), passant par les ouvertures (22) de la partie supérieure (2) de la boîte de connexion.

12. Utilisation du boîtier selon l'une quelconque des revendications 1 à 10 pour raccorder un dispositif de filtration (6) à la grille monophasée ou triphasée.

13. Un dispositif électronique avec boîtier selon l'une quelconque des revendications 1 à 10, le dispositif électronique étant un dispositif de filtration, de mesure, de connexion, de blocage, de transmission ou de protection.
